(19) **Europäisches Patentamt / European Patent Office / Office européen des brevets**

(11) **EP 2 689 262 B1**

(12) **EUROPEAN PATENT SPECIFICATION**

(45) Date of publication and mention of the grant of the patent:
**13.04.2016 Bulletin 2016/15**

(21) Application number: **12703423.9**

(22) Date of filing: **05.01.2012**

(51) Int Cl.:
**G01R 33/565** $^{(2006.01)}$

(86) International application number:
**PCT/AT2012/050002**

(87) International publication number:
**WO 2012/129585 (04.10.2012 Gazette 2012/40)**

(54) **UNWRAPPING PHASE IMAGES IN MAGNETIC RESONANCE IMAGING**

UNWRAPPING VON PHASENBILDERN IN DER MAGNETRESONANZBILDGEBUNG

DÉROULEMENT D'IMAGES DE PHASE DANS UNE IMAGERIE PAR RÉSONANCE MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.03.2011 EP 11450043**

(43) Date of publication of application:
**29.01.2014 Bulletin 2014/05**

(73) Proprietor: **Medizinische Universität Wien 1090 Wien (AT)**

(72) Inventor: **ROBINSON, Simon A-1160 Vienna (AT)**

(74) Representative: **Weiser, Andreas Patentanwalt Kopfgasse 7 1130 Wien (AT)**

(56) References cited:
**US-A1- 2009 256 567**

- **FUNAI A K ET AL: "Regularized field map estimation in MRI", IEEE TRANSACTIONS ON MEDICAL IMAGING IEEE USA, vol. 27, no. 10, October 2008 (2008-10), pages 1484-1494, XP002657572, ISSN: 0278-0062**
- **ROBINSON SIMON ET AL: "Combining Phase Images From Multi-Channel RF Coils Using 3D Phase Offset Maps Derived From a Dual-Echo Scan", MAGNETIC RESONANCE IN MEDICINE, vol. 65, no. 6, 19 February 2011 (2011-02-19), pages 1638-1648, XP002657573,**
- **ANDRIS P ET AL: "Simple and accurate unwrapping phase of MR data", MEASUREMENT ELSEVIER SCIENCE LTD. UK, vol. 42, no. 5, June 2009 (2009-06), pages 737-741, XP002657571, ISSN: 0263-2241**

**Description**

The present invention relates to a method of unwrapping a phase image in Magnetic Resonance Imaging (MRI).

MRI is used in radiology to visualize details of structures in a patient's body. For aligning the magnetic spin of the nuclei, mostly of protons in water molecules in the body tissue, the patient is placed inside a powerful static magnetic field. Excited by an electro-magnetic radio-frequency pulse the nuclei resonating at this frequency deflect and then gradually relax towards the static field while emitting detectable magnetic radiation, which can be captured as an "echo" at a certain time after excitation ("echo time"). Relaxation times and resonance frequency of the nuclei depend both on local properties of the tissue material, which represents the underlying principle allowing visualization of these properties, and the magnetic field strength. By superposing lateral and longitudinal gradient fields and adjusting the excitation frequency, certain volumetric regions ("voxels") can be measured by both selective excitation and frequency analysis of the captured echo signals. Fourier-transforming the latter generates complex representations of the frequency values and their phases, which can be made readable.

When the excitation is performed on two-dimensional slices, they are selected by adjusting the gradients in the magnetic field strength, thereafter resonant frequency values are captured and processed, forming 2D-images multiple of which can be merged to form a 3D-representation. Most procedures in MRI are therefore executed on pixels of 2D-images. In 3D imaging, a thick volume of tissue is excited instead of a thin section, and slice encoding is replaced by an additional gradient loop in the slice direction.

In the past, magnitude values have been used primarily from the complex representations of the MR-signal. Nevertheless, its phase values allow for the extraction of additional information about local properties inside the tissue. Specifically in MRI at higher magnetic field strengths, which promise better images, this additional information would be useful to support the enhancement of image quality. Therefore applications using the phase information of complex MR-images become increasingly important.

However, phase images suffer from a conceptual ambiguity: As adding 2n to a phase value results in the same phase, the encoding range in captured phase values is effectively limited to 2n radians. Variations in phase of an object when passing through 2n lead to discontinuities in the image known as "phase wraps", which distort the readability and obscure interesting phase features.

A number of methods has been developed for removing phase wraps, which can broadly be categorised as spatial or as temporal unwrapping methods. Spatial unwrapping methods use phase changes of more than n between spatially adjacent voxels as identifiers for a wrap in a region-growing approach. These methods only require one phase image but are computationally complex and prone to error specifically at regions of higher phase variation (e.g. close to veins).

Temporal unwrapping methods, which analyse phase evolution over time for each voxel - or pixel - separately, are more robust and computationally simpler. They are based on exploiting the difference in two or more phase images acquired at different echo times, e.g. us 2009/0256567 A1 or Funai A. K. et al, "Regularized Field Map Estimation in MRI", IEEE Transactions on Medical Imaging, IEEE USA, vol. 27, no. 10, October 2008, pages 1484 - 1494. If the spacing between these echo times is sufficiently small, wrap-free phase difference images are obtained.

To acquire several phase images at different echo times, two possibilities are known in the art. The first one is to acquire multiple images after a single excitation ("multi-echo images"). Multi-echo images are limited in the minimum echo time spacing, as the acquisition of each echo takes a finite amount of time. This time is determined by the acquisition rate (which in turn determines the SNR) and the number of samples, and is typically around 5 ms for a high SNR, high resolution image. However, an echo time spacing of this size is too long to reliably avoid phase wraps in phase difference images, where echo time spacings of around 0.1 - 2 ms would be necessary, depending on local field deviations.

A second possibility is to use repeated single-echo acquisitions with slightly different echo times. In this way the echo time spacing can be chosen to be arbitrarily low. However, this method suffers from a substantially extended measurement time, as a complete excitation cycle has to be executed for each echo acquisition. Thus, acquiring three echo images with repeated single-echo acquisition takes roughly three times as long as in multi-echo acquisition. In addition, errors are likely to occur due to interim changes in the tissue (e.g. patient motion) between the individual image acquisitions.

As a general drawback, temporal unwrapping methods do not yield unwrapped phase images but rather unwrapped phase difference images. Wrap-free phase difference images have much lower contrast between grey and white matter than unwrapped phase images.

It is therefore an object of the invention to provide a method for unwrapping phase images with high contrast, which unwraps a larger range of phase values than known multi-echo acquisition methods and which performs faster than known single-echo acquisition methods.

In a first aspect of the invention this object is met by a method of unwrapping a phase image in magnetic resonance imaging, comprising

acquiring three phase images at three different echo times following a single excitation with unequal echo time spacings therebetween,
calculating a first difference image between the first two and a second difference image between the last two of said three phase images and calculating a third difference image between the first and the second difference images, generating a phase correction map from said third difference image, and
adding said phase correction map to one of said phase images acquired.

By exploiting multi-echo images following a single excitation the method of the invention allows for a temporal unwrapping of phase images which can be performed quickly. At the same time limitations in the phase range which can be unwrapped are overcome by calculating a third difference image as a "difference-of-differences image", the relevant time base of which is determined solely by the *difference* in the echo time spacings of the first and the second and the second and the third acquisition images, respectively. This difference in echo time spacings can be chosen - with the only limitation of signal-to-noise ratio (SNR) considerations - as small as possible and thus phase wraps in the third difference image can be avoided over a broad range of signal phases in the object to be investigated, even though their phase value representations per se are limited to 2n. Applying information from this third difference image via a phase correction map to one of the original phase images yields an unwrapped phase image rather than only phase difference images, and avoids the loss of contrast as a consequence. Unwrapped phase images obtained with the method of the invention have both better contrast and higher SNR.

According to a preferred embodiment of the invention the step of generating the phase correction map comprises scaling said third difference image by a scaling factor,
subtracting said scaled third difference image from the phase image to unwrap, and
quantizing the result of said subtraction in steps of 2n, to obtain the phase correction map.

In this way the invention provides for a quantized phase correction map, which is individual for each phase image to unwrap, contains only multiple values of 2n and can be generated with low computational complexity. The phase correction map can be directly applied to unwrap the phase image by adding on a pixel-by-pixel basis.

According to a further preferred embodiment of the invention, said scaling factor is formed by dividing the echo time of the phase image to unwrap by the difference between said echo time spacings. By this means the scaling factor adapts to changes of the difference in echo time spacings accordingly.

It is another object of the invention to reduce loss of information and deterioration of the SNR, respectively, which arise as a consequence of calculating differences between images, thereby achieving a better SNR in an unwrapped phase image. This object is specifically met in the further preferred embodiment of the invention wherein the step of generating the phase correction map comprises
scaling said third difference image by a first scaling factor formed by dividing the first echo time spacing by the difference between said echo time spacings, subtracting this scaled third difference image and the first difference image from each other, quantizing the result in steps of 2n, and adding the quantized result to the first difference image, to obtain an ameliorated first difference image;
scaling said third difference image by a second scaling factor formed by dividing the second echo time spacing by the difference between said echo time spacings, subtracting this scaled third difference image and the second difference image from each other, quantizing the result in steps of $2\pi$, and adding the quantized result to the second difference image, to obtain an ameliorated second difference image;
calculating an ameliorated third difference image between the ameliorated first and second difference images;
scaling said ameliorated third difference image by said scaling factor;
subtracting said scaled ameliorated third difference image from the phase image to unwrap; and
quantizing the result of said subtraction in steps of 2n, to obtain the phase correction map.

The steps of ameliorating both the first and second difference images extends their range of phase difference values. When re-calculating the third difference image using the ameliorated first and second difference images, it will be enhanced in terms of its SNR. The enhanced SNR of the ameliorated third difference image increases the precision in the subsequent steps of unwrapping.

It is a further object of the invention to additionally compensate a phase image for phase offsets due to differences in propagation lengths through different tissues to each receiver coil as they pick up the emitted magnetic radiation of the nuclei during their relaxation phase, which lead to so-called "receiver offset phase wraps". To this end the invention provides for a method for unwrapping and offset-compensating a phase image in magnetic resonance imaging, comprising
unwrapping a first and a second phase image each according to the method of any of the claims 1 to 3;
calculating an offset image from said first and second unwrapped phase images according to

$$\theta_{rx} = \frac{\theta_2' \cdot TE_1 - \theta_1' \cdot TE_2}{TE_2 - TE_1}$$

with

θ_{rx} being said offset image,
θ_{1}' being said first unwrapped phase image,
θ_{2}' being said second unwrapped phase image,
$TE_{1}$ being said first echo time, and
$TE_{2}$ being said second echo time;

subtracting the offset image from an unwrapped phase image to be offset-compensated, to obtain a modified offset image;
scaling said third difference image by said scaling factor;
subtracting said scaled result and said modified offset image from each other;
quantizing the subtraction result in steps of 2n; and adding the quantized result to said modified offset image.

The additional steps of offset-compensation can be applied both to unwrapped phase images based on a third difference image as described above as well as to unwrapped phase images based on an ameliorated third difference image according to the following embodiment of the method, comprising

unwrapping a first and a second phase image each according to the method of claim 4;
calculating an offset image from said first and second unwrapped phase images according to

$$\theta_{rx} = \frac{\theta_2^{'} \cdot TE_1 - \theta_1^{'} \cdot TE_2}{TE_2 - TE_1}$$

with

θ_{rx} being said offset image,
θ_{1}' being said first unwrapped phase image,
θ_{2}' being said second unwrapped phase image,
$TE_{1}$ being said first echo time, and
$TE_{2}$ being said second echo time;

subtracting the offset image from an unwrapped phase image to be offset-compensated, to obtain a modified offset image;
scaling said ameliorated third difference image by said scaling factor;
subtracting said scaled result and the modified offset image from each other;
quantizing the subtraction result in steps of 2n; and
adding the quantized result to said modified offset image.

By using the ameliorated third difference image for creating unwrapped phase images instead of the third difference image the precision of the finally unwrapped and offset-compensated phase images can be enhanced.

The invention will now be described in further detail by means of exemplary embodiments thereof under reference to the enclosed drawings in which:

Fig. 1 shows the generation of a complex 2D-image in MRI according to the state of the art,
Fig. 2 shows a flow chart of a first embodiment of the method of the invention for unwrapping the phase image of a complex 2D-image,
Fig. 3 depicts a timing diagram of a multi-echo MR-image acquisition cycle used in the method of Fig. 2,
Fig. 4 depicts exemplary input and output images of the individual steps of the method of Fig. 2,
Fig. 5 shows a flow chart of a first embodiment of the steps of generating a phase correction map of the method in Fig. 2 in detail,
Fig. 6 shows a flow chart of a second embodiment of the steps of generating a phase correction map of the method in Fig. 2 in detail,
Fig. 7 depicts exemplary input and output images of the individual steps of the embodiment of Fig. 6
Fig. 8 shows a flow chart of a further embodiment of the method of the invention for unwrapping and offset-compensating a phase image, and
Fig. 9 depicts exemplary input and output images of the individual steps of the embodiment of Fig. 8.

MRI is used in radiology to visualize soft tissues, non-invasively and in vivo. The process of generating an image of a patient usually consists of the following steps: creating a bulk (longitudinal) magnetisation in the tissue by placing the patient inside a powerful static magnetic field; creating regional variation in this magnetic field, and thereby in the resonant frequency of the nuclei, with three comparatively small, linear perpendicular magnetic fields ("gradients"); disturbing the magnetisation with pulses of radio-frequency (RF) electromagnetic radiation applied at the resonant frequency, tipping the magnetisation into the transverse plane (which is perpendicular to the static magnetic field); and acquiring the RF signals emitted by the tissues as the magnetisation relaxes to the longitudinal direction.

In 2D tomographic imaging, spacing encoding of the signal works as follows. The first gradient field ("slice select") is applied during RF excitation, so that only spins in a narrow section of tissue are excited. The second ("readout") is applied while the signal is being acquired, so that spins along the readout axis are encoded by their resonant frequency. A number of such excitation-readout steps are acquired with differing applications of the third ("phase-encode") gradient, which encodes the signal along that gradient direction according to dephasing rate. In 3D imaging, slice encoding is replaced by a second loop of phase-encoding steps in the slice gradient direction.

The RF signals emitted by the patient are captured as "echoes" at a certain time after excitation by multiple receiver coils. Fourier-transforming the acquired MR signals generates images of the patient, which consist of a large number of voxels, i.e. pixels in the 2D-slices, reflecting the local proton density and magnetic properties of the tissue. The acquired MR signals are complex valued. Images of the patient, as the Fourier-transform of the acquired signal, are therefore likewise complex valued, that is, image signals consist of a magnitude and a phase and can be represented in conventional complex number notation.

Some MRI methods use only the magnitude of the MR-signal. Nevertheless, the phase contains additional information, which can be clinically useful. While the magnitude of the signal decays exponentially with echo time, phase evolves linearly, and reflects local deviation from the main magnetic field strength. For this reason, two or more phase images acquired at different echo times can be used to map the local magnetic field ("field mapping"). The sensitivity of phase to local magnetic field also allows local iron (which is highly paramagnetic) to be imaged. Phase can be used, in combination with magnitude, to depict veins, due to the iron content of the deoxyhemoglobin iron, in a technique known as Susceptibility-Weighted Imaging. These techniques benefit from high static magnetic field, which provides enhanced magnetic susceptibility effects and higher quality images due to increased SNR.

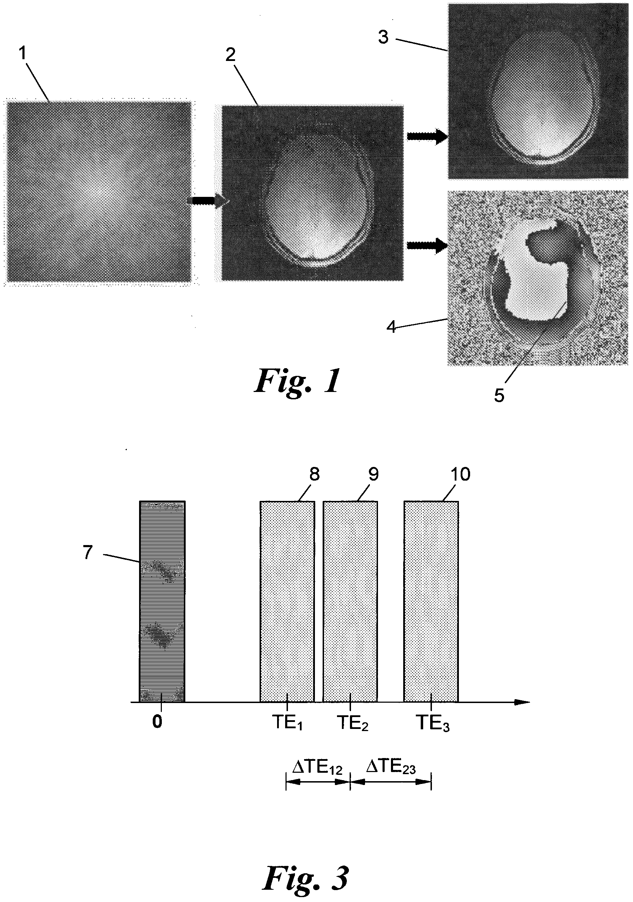

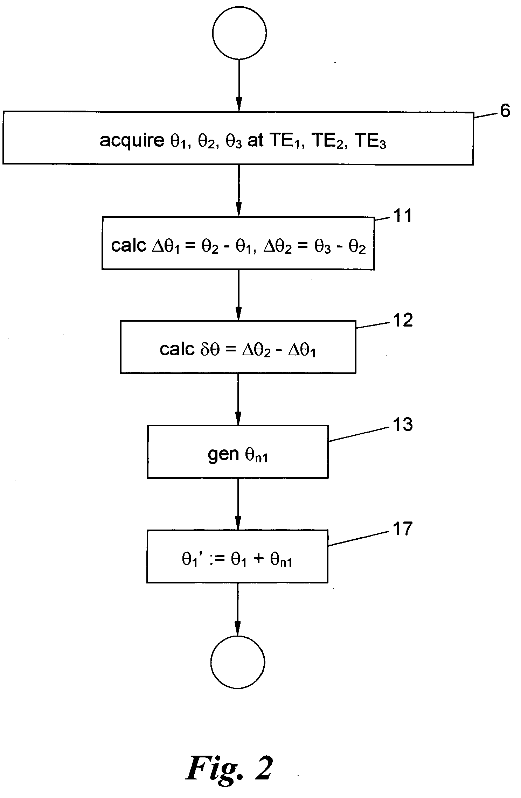

As shown in Fig. 1, captured signals of an acquired two-dimensional MR-image 1 of an object to be investigated cannot be interpreted straightforwardly. 2D-Fourier-transforming image 1 results in a complex image 2 which can be separated on a pixel-by-pixel basis into a magnitude image 3 and a phase image 4. The phase image 4 typically shows phase wraps 5 because of the limitation in the encoding range to 2n discussed at the outset. Figs. 2 to 4 show a first embodiment of a method to remove ("unwrap") such phase wraps 5 from a phase image 4.

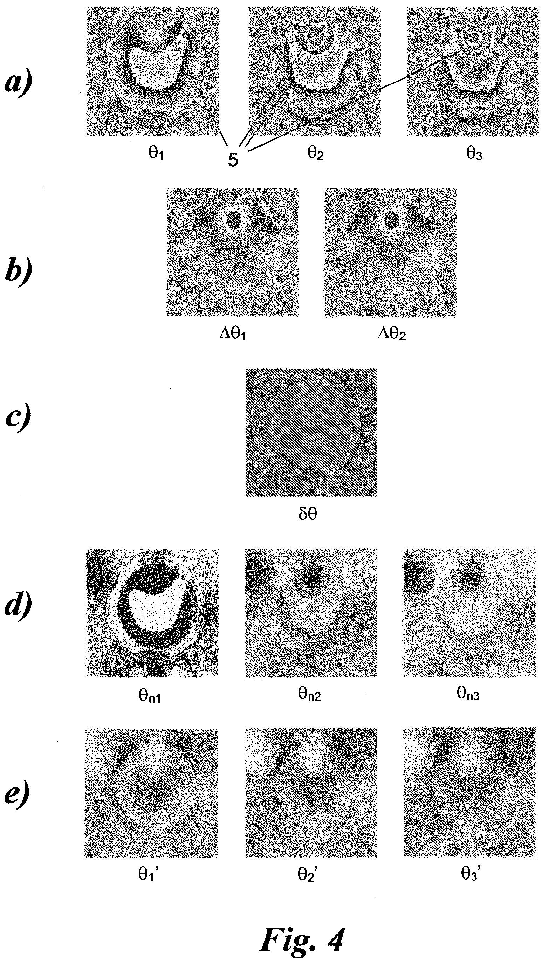

According to Fig. 2, in a first step 6 of the method of unwrapping, three MR-images are acquired at three different echo times $TE_1$, $TE_2$ and $TE_3$ following a single excitation pulse 7 as shown in Fig. 3; step 6 leads to three phase images $\theta_1$, $\theta_2$, $\theta_3$ examples of which are depicted in Fig. 4a. The phase images $\theta_1$, $\theta_2$, $\theta_3$ typically show phase wraps 5.

As detailed in Fig. 3, the acquisition of each of the phase images $\theta_1$, $\theta_2$, $\theta_3$ at the three different echo times $TE_1$, $TE_2$, $TE_3$ takes a certain, finite acquisition period 8, 9, 10. The echo times $TE_1$, $TE_2$, $TE_3$ are chosen so that their respective time spacings $\Delta TE_{12} = TE_2 - TE_1$ and $\Delta TE_{23} = TE_3 - TE_2$ are not the same, i.e. unequal. Further more, the echo times $TE_1$, $TE_2$, $TE_3$ are preferably also chosen in such a way that the acquisition periods 8, 9 and 10 do not overlap. Because of the unequal echo time spacings $\Delta TE_{12} \neq \Delta TE_{23}$ a difference $\delta TE$ can be calculated as

$$\delta TE = \Delta TE_{12} - \Delta TE_{23} = \left(TE_2 - TE_1\right) - \left(TE_3 - TE_2\right) \tag{1}$$

The echo time spacing $\Delta TE_{12}$ can be greater or less than the echo time spacing $\Delta TE_{23}$. It is also possible to acquire more than three phase images $\theta_1$, $\theta_2$, $\theta_3$ at more than three echo times $TE_1$, $TE_2$, $TE_3$ and choose three of them for the further unwrapping.

Returning to Fig. 2, in a next step 11 a pixel-by-pixel difference between the first and the second phase images $\theta_1$, $\theta_2$ is calculated to form a first difference image $\Delta\theta_1 = \theta_2 - \theta_1$, and a pixel-by-pixel difference between the second and the third phase images $\theta_2$, $\theta_3$ is calculated to form a second difference image $\Delta\theta_2 = \theta_3 - \theta_2$. Fig. 4b shows examples of phase difference images $\Delta\theta_1$ and $\Delta\theta_2$ deriving from calculation step 11.

In the present disclosure, "Calculating a difference" between phase images $\theta_1$, $\theta_2$, $\theta_3$ (or phase difference images $\Delta\theta_1$, $\Delta\theta_2$) shall mean any operation which takes into account and eliminates effects of phase values being truncated due to passing the bounds at 0 or 2n according to the following set of equations (2):

$$\text{if} \quad -\pi \le \left(\varphi_2 - \varphi_1\right) \le \pi \quad \text{then} \quad \Delta\varphi = \varphi_2 - \varphi_1$$

$$\text{if} \quad \left(\varphi_2 - \varphi_1\right) > \pi \quad \text{then} \quad \Delta\varphi = \left(\varphi_2 - \varphi_1\right) - 2\pi \qquad (2)$$

$$\text{if} \quad \left(\varphi_2 - \varphi_1\right) < -\pi \quad \text{then} \quad \Delta\varphi = 2\pi + \left(\varphi_2 - \varphi_1\right)$$

with

$\varphi_1, \varphi_2$ being phase values of corresponding pixels in the respective input phase images ($\theta_1, \theta_2, \theta_3$) or phase difference images ($\Delta\theta_1, \Delta\theta_2$), and
$\Delta\varphi$ being the phase value of a corresponding pixel in the respective output phase difference image ($\Delta\theta_1 = \theta_2 - \theta_1$, $\Delta\theta_2 = \theta_3 - \theta_2$, $\delta\theta = \Delta\theta_2 - \Delta\theta_1 = [\theta_3 - \theta_2] - [\theta_2 - \theta_1]$) of the operation for calculating a difference.

Any equivalent mathematical operation performing the same task can be used and is comprised by the term "calculating a difference".

Subsequently, in step 12 a third difference image $\delta\theta$ is formed as a pixel-by-pixel difference - according to equation (2) - between the first and second difference images $\Delta\theta_1, \Delta\theta_2$, i.e. $\delta\theta = \Delta\theta_2 - \Delta\theta_1$. An example of the third difference image $\delta\theta$ is illustrated in Fig. 4c.

Of course, the third difference image $\delta\theta$ could be equivalently calculated from the phase images $\theta_1, \theta_2, \theta_3$ directly as $(\theta_3 - \theta_2) - (\theta_2 - \theta_1) = \theta_3 - 2\theta_2 + \theta_1$ as a pixel-by-pixel difference according to equation (2). It is therefore clear that steps 11 and 12 could be performed in a single calculation step, without necessarily having calculated the first and the second difference images $\Delta\theta_1, \Delta\theta_2$ explicitly in the steps 11 and 12. As a consequence, the term "calculating the third difference image between the first and the second difference images" comprises also this equivalent in the context of the present application.

The difference $\delta TE$ in echo time spacings $\Delta TE_{12}, \Delta TE_{23}$ is chosen to be less than the time it takes for the phase to change by 2n in the pixels to unwrap, which time is determined by the local deviation from the static magnetic field, to avoid phase wraps in the third difference image $\delta\theta$ as best as possible.

In step 13, a phase correction map $\theta_{n1}$ is generated on the basis of the third difference image $\delta\theta$ for unwrapping the first phase image $\theta_1$. While the following description of the method deals with unwrapping the first phase image $\theta_1$, it should be noted that any other phase image $\theta_2, \theta_3$ could be unwrapped with respective phase correction maps $\theta_{n2}$, $\theta_{n3}$ calculated accordingly, see Fig. 4d.

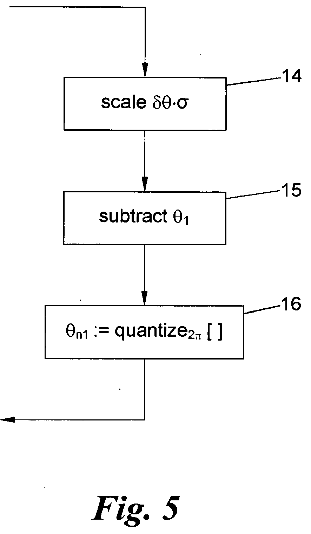

Fig. 5 shows a first variant of generating the phase correction map $\theta_{n1}$ in detail. First, in block 14 the third difference image $\delta\theta$ is scaled with a scaling factor $\sigma$ individual for the phase image $\theta_1$ to unwrap using its echo time $TE_1$ according to

$$\sigma = \frac{TE_1}{\delta TE} \qquad (3)$$

Next a difference between the phase image $\theta_1$ and the scaling result of step 14 is formed (step 15) and fed into a quantizing step 16 which quantizes the result in steps of 2n to obtain the phase correction map $\theta_{n1}$, which thus contains only values of multiples of 2n (i.e. 0, 2n, 4n etc.). Equation (4) illustrates steps 14 to 16 in short form:

$$\theta_{n1} = \left\lVert \frac{\theta_1 - \sigma \cdot \delta\theta}{2\pi} \right\rVert \cdot 2\pi \qquad (4)$$

The operator $\lVert \cdot \rVert$ in the present disclosure shall denote the function of rounding to the nearest integer.

Returning to Fig. 2, in a final step 17 the phase correction map $\theta_{n1}$ is added pixel-by-pixel to the phase image $\theta_1$ to obtain an unwrapped phase image $\theta_1'$. The unwrapped phase image $\theta_1'$ is shown in Fig. 4e, together with further unwrapped phase images $\theta_2'$ and $\theta_3'$ calculated accordingly for the phase images $\theta_2$ and $\theta_3$, respectively.

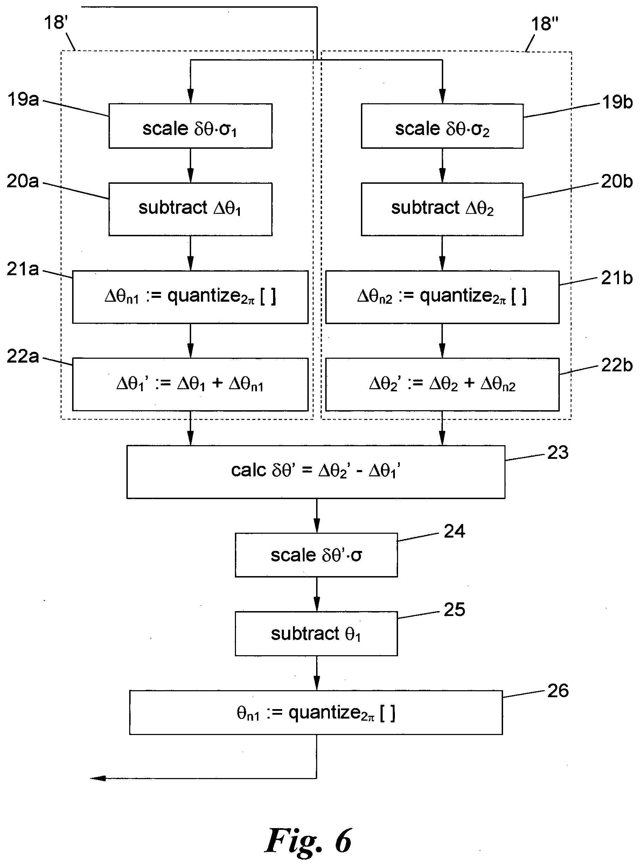

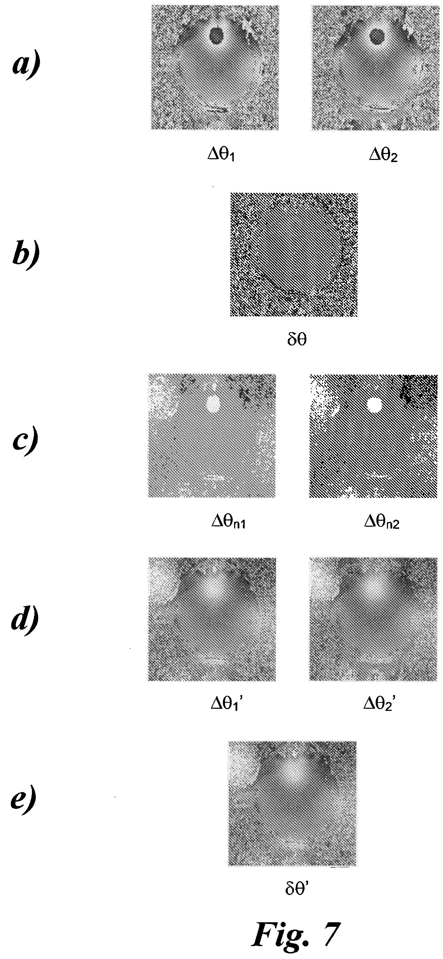

Fig. 6 shows an alternative to Fig. 5 for generating the phase correction map $\theta_{n1}$ in step 13. In this embodiment, each of the first and second difference images $\Delta\theta_1, \Delta\theta_2$ (Fig. 7a) is ameliorated by unwrapping it in a separate branch 18', 18" using the third difference image $\delta\theta$ (Fig. 7b) much in the same way as in steps 14 to 16 of the above embodiment. Subsequently, the third difference $\delta\theta$ image is re-calculated on the basis of such ameliorated first and second difference images $\Delta\theta_1', \Delta\theta_2'$ to obtain an ameliorated third difference image $\delta\theta'$ with enhanced SNR, providing an alternative basis for generating the phase correction map $\theta_{n1}$.

To unwrap the first difference image $\Delta\theta_1$ in branch 18' the third difference image $\delta\theta$ is first scaled by a first scaling factor $\sigma_1$ according to block 19a and equation (5):

$$\sigma_1 = \frac{(TE_2 - TE_1)}{\delta TE} \qquad (5)$$

In step 20a the scaling result is subtracted from the first difference image $\Delta\theta_1$, and in step 21a the result of the subtraction is quantized in steps of 2n, forming a difference correction map $\Delta\theta_{n1}$ (Fig. 7c) according to

$$\Delta\theta_{n1} = \left\| \frac{\Delta\theta_1 - \sigma_1 \cdot \delta\theta}{2\pi} \right\| \cdot 2\pi \qquad (6)$$

By adding the difference correction map $\Delta\theta_{n1}$ to the first difference image $\Delta\theta_1$ an ameliorated first difference image $\Delta\theta_1$' is obtained, see step 22a and Fig. 7d.

In branch 18" analogous steps 19b to 22b are applied to unwrap the second difference image $\Delta\theta_2$ and obtain an ameliorated second difference image $\Delta\theta_2$'.

By calculating a difference between the ameliorated first and second difference images $\Delta\theta_1$', $\Delta\theta_2$' in step 23 an ameliorated third difference image $\delta\theta$' = $\Delta\theta_2$' - $\Delta\theta_1$' is obtained (Fig. 7e).

The following steps to obtain the phase correction map $\theta_{n1}$ in blocks 24, 25 and 26 are performed in a similar way as illustrated in Fig. 5, except for the fact that the calculation is now based on the ameliorated third difference image $\delta\theta$' instead of the third difference image $\delta\theta$.

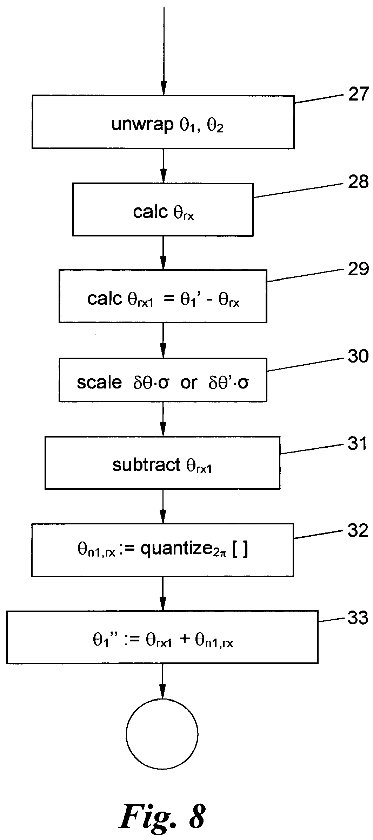

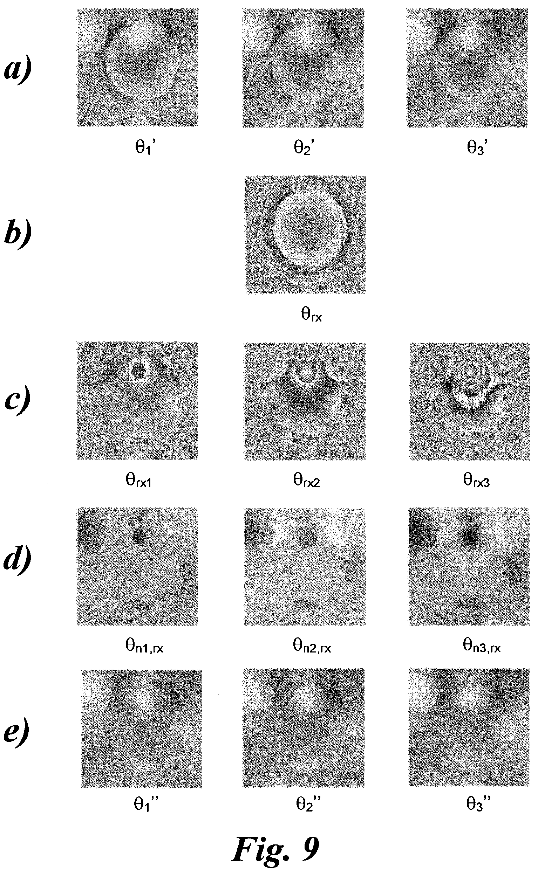

Figs. 8 and 9 show an optional addition to the methods of Figs. 2 to 7 for removing wraps due to receiver offsets. In a first step 27 at least two unwrapped phase images $\theta_1$', $\theta_2$' (Fig. 9a) are obtained from the three acquired phase images $\theta_1$, $\theta_2$, $\theta_3$ according to one of the methods detailed above.

Next, a receiver offset image $\theta_{rx}$ (Fig. 9b) is calculated in block 28 according to equation (7):

$$\theta_{rx} = \frac{\theta_2' \cdot TE_1 - \theta_1' \cdot TE_2}{TE_2 - TE_1} \qquad (7)$$

It should be noted that any other combination of two unwrapped phase images $\theta_1$', $\theta_2$', $\theta_3$' could be used together with the respective echo times $TE_1$, $TE_2$, $TE_3$ to calculate the receiver offset image $\theta_{rx}$.

In step 29 the receiver offset image $\theta_{rx}$ is subtracted from the unwrapped phase image $\theta_1$', $\theta_2$', $\theta_3$' to be offset-compensated, here $\theta_1$', to obtain a modified offset image $\theta_{rx1}$ an example of which can be seen in Fig. 9c.

The third difference image $\delta\theta$ - or alternatively the ameliorated third difference image $\delta\theta$' - is then scaled by means of the scaling factor $\sigma$ (step 30), the result is subtracted from the respective modified offset image $\theta_{rx1}$ in block 31, and an offset-correction map $\theta_{n1,rx}$ (Fig. 9d) is obtained in step 32 by quantizing the result of step 31 in steps of 2n according to

$$\theta_{n1,rx} = \left\| \frac{\theta_{rx1} - \sigma \cdot \delta\theta'}{2\pi} \right\| \cdot 2\pi \qquad (8)$$

By adding the offset-correction map $\theta_{n1,rx}$ to the modified offset image $\theta_{rx1}$ an unwrapped and offset-compensated phase image $\theta_1$" (Fig. 9e) is generated in block 33. By applying steps 29 to 33 to other unwrapped phase images $\theta_2$', $\theta_3$' accordingly, unwrapped and phase offset-compensated phase images $\theta_2$", $\theta_3$" can be obtained (Fig. 9e).

The invention is not limited to the preferred embodiments described in detail above but encompasses all variants and modifications thereof which will become apparent for the person skilled in the art from the present disclosure and which fall into the scope of the appended claims.

**Claims**

1. A method of unwrapping a phase image ($\theta_1$) in Magnetic Resonance Imaging, comprising
   acquiring three phase images ($\theta_1$, $\theta_2$, $\theta_3$) at three different echo times ($TE_1$, $TE_2$, $TE_3$) following a single excitation with unequal echo time spacings ($\Delta TE_{12}$, $\Delta TE_{23}$) therebetween,
   calculating a first difference image ($\Delta\theta_1$) between the first two and a second difference image ($\Delta\theta_2$) between the last two of said three phase images ($\theta_1$, $\theta_2$, $\theta_3$) and calculating a third difference image ($\delta\theta$) between the first and the second difference images ($\Delta\theta_1$, $\Delta\theta_2$),
   generating a phase correction map ($\theta_{n1}$) on the basis of at least said third difference image ($\delta\theta$) and the phase image ($\theta_1$) to unwrap, and
   adding said phase correction map ($\theta_{n1}$) to the phase image ($\theta_1$) to unwrap of said phase images ($\theta_1$, $\theta_2$, $\theta_3$) acquired.

2. The method of claim 1, wherein the step of generating the phase correction map ($\theta_{n1}$) comprises
   scaling said third difference image ($\delta\theta$) by a scaling factor ($\sigma$),
   subtracting said scaled third difference image from the phase image ($\theta_1$) to unwrap, and
   quantizing the result of said subtraction in steps of 2n, to obtain the phase correction map ($\theta_{n1}$).

3. The method of claim 2, wherein said scaling factor ($\sigma$) is formed by dividing the echo time ($TE_1$) of the phase image ($\theta_1$) to unwrap by the difference ($\delta TE$) between said echo time spacings ($\Delta TE_{12}$, $\Delta TE_{23}$).

4. The method of claim 1, wherein the step of generating the phase correction map ($\theta_{n1}$) comprises
   scaling said third difference image ($\delta\theta$) by a first scaling factor ($\sigma_1$) formed by dividing the first echo time spacing ($\Delta TE_{12}$) by the difference ($\delta TE$) between said echo time spacings ($\Delta TE_{12}$, $\Delta TE_{23}$), subtracting this scaled third difference image from the first difference image ($\Delta\theta_1$), quantizing the result in steps of 2n, and adding the quantized result to the first difference image ($\Delta\theta_1$), to obtain an ameliorated first difference image ($\Delta\theta_1$') ;
   scaling said third difference image ($\delta\theta$) by a second scaling factor ($\sigma_2$) formed by dividing the second echo time spacing ($\Delta TE_{23}$) by the difference ($\delta TE$) between said echo time spacings ($\Delta TE_{12}$, $\Delta TE_{23}$), subtracting this scaled third difference image from the second difference image ($\Delta\theta_2$), quantizing the result in steps of 2n, and adding the quantized result to the second difference image ($\Delta\theta_2$), to obtain an ameliorated second difference image ($\Delta\theta_2$');
   calculating an ameliorated third difference image ($\delta\theta$') between the ameliorated first and second difference images ($\Delta\theta1$', $\Delta\theta_2$');
   scaling said ameliorated third difference image ($\delta\theta$') by said scaling factor ($\sigma$);
   subtracting said scaled ameliorated third difference image from the phase image ($\theta_1$) to unwrap; and
   quantizing the result of said subtraction in steps of 2n, to obtain the phase correction map ($\theta_{n1}$).

5. A method for unwrapping and offset-compensating a phase image ($\theta_1$) in Magnetic Resonance Imaging, comprising:

   unwrapping a first and a second phase image ($\theta_1$, $\theta_2$) each according to the method of any of the claims 1 to 3;
   calculating an offset image ($\theta_{rx}$) from said first and second unwrapped phase images ($\theta_1$', $\theta_2$') according to

   $$\theta_{rx} = \frac{\theta_2' \cdot TE_1 - \theta_1' \cdot TE_2}{TE_2 - TE_1}$$

   with

   > $\theta_{rx}$ being said offset image,
   > $\theta_1$' being said first unwrapped phase image,
   > $\theta_2$' being said second unwrapped phase image,
   > $TE_1$ being said first echo time, and
   > $TE_2$ being said second echo time;

   subtracting the offset image ($\theta_{rx}$) from an unwrapped phase image ($\theta_1$') to be offset-compensated, to obtain a modified offset image ($\theta_{rx1}$);
   scaling said third difference image ($\delta\theta$) by said scaling factor ($\sigma$) ;
   subtracting said scaled result from said modified offset image ($\theta_{rx1}$);
   quantizing the subtraction result in steps of 2n; and

adding the quantized result to said modified offset image ($\theta_{rx1}$).

6. A method for unwrapping and offset-compensating a phase image ($\theta_1$) in Magnetic Resonance Imaging, comprising:

unwrapping a first and a second phase image ($\theta_1$, $\theta_2$) each according to the method of claim 4;
calculating an offset image ($\theta_{rx}$) from said first and second unwrapped phase images ($\theta_1$', $\theta_2$') according to

$$\theta_{rx} = \frac{\theta_2' \cdot TE_1 - \theta_1' \cdot TE_2}{TE_2 - TE_1}$$

with

$\theta_{rx}$ being said offset image,
$\theta_1$' being said first unwrapped phase image,
$\theta_2$' being said second unwrapped phase image,
$TE_1$ being said first echo time, and
$TE_2$ being said second echo time;

subtracting the offset image ($\theta_{rx}$) from an unwrapped phase image ($\theta_1$') to be offset-compensated, to obtain a modified offset image ($\theta_{rx1}$) ;
scaling said ameliorated third difference image ($\delta\theta$') by said scaling factor ($\sigma$);
subtracting said scaled result from said modified offset image ($\theta_{rx1}$) ;
quantizing the subtraction result in steps of 2n; and
adding the quantized result to said modified offset image ($\theta_{rx1}$).

**Patentansprüche**

1. Verfahren zum Entfalten eines Phasenbilds ($\theta_1$) in der Magnetresonanz-Bildgebung, umfassend
Erfassen von drei Phasenbildern ($\theta_1$, $\theta_2$, $\theta_3$) zu drei verschiedenen Echozeiten ($TE_1$, $TE_2$, $TE_3$) nach einer einzigen Anregung mit ungleichen Echozeitabständen ($\Delta TE_{12}$, $\Delta TE_{23}$) dazwischen,
Berechnen eines ersten Differenzbilds ($\Delta\theta_1$) zwischen den ersten beiden und eines zweiten Differenzbilds ($\Delta\theta_2$) zwischen den letzten beiden der genannten drei Phasenbildern ($\theta_1$, $\theta_2$, $\theta_3$) und Berechnen eines dritten Differenzbilds ($\delta\theta$) zwischen dem ersten und dem zweiten Differenzbild ($\Delta\theta_1$, $\Delta\theta_2$) ;
Erzeugen einer Phasenkorrekturkarte ($\theta_{n1}$) basierend auf zumindest dem genannten dritten Differenzbild ($\delta\theta$) und dem zu entfaltenden Phasenbild ($\theta_1$), und
Hinzufügen der genannten Phasenkorrekturkarte ($\theta_{n1}$) zu dem zu entfaltenden Phasenbild ($\theta_1$) der erfassten Phasenbilder ($\theta_1$, $\theta_2$, $\theta_3$),

2. Verfahren nach Anspruch 1, wobei der Schritt des Erzeugens der Phasenkorrekturkarte ($\theta_{n1}$) umfasst
Skalieren des genannten dritten Differenzbilds ($\delta\theta$) um einen Skalierfaktor ($\sigma$),
Subtrahieren des genannten skalierten dritten Differenzbilds von dem zu entfaltenden Phasenbild ($\theta_1$), und
Quantisieren des Ergebnisses der genannten Subtraktion in Schritten von 2n, um die Phasenkorrekturkarte ($\theta_{n1}$) zu erhalten.

3. Verfahren nach Anspruch 2, wobei der genannte Skalierfaktor ($\sigma$) durch Dividieren der Echozeit ($TE_1$) des zu entfaltenden Phasenbilds ($\theta_1$) durch die Differenz ($\delta TE$) zwischen den genannten Echozeitabständen ($\Delta TE_{12}$, $\Delta TE_{23}$) gebildet wird.

4. Verfahren nach Anspruch 1, wobei der Schritt des Erzeugens der Phasenkorrekturkarte ($\theta_{n1}$) umfasst
Skalieren des genannten dritten Phasenbilds ($\delta\theta$) um einen ersten Skalierfaktor ($\sigma_1$), der durch Dividieren des ersten Echozeitabstands ($\Delta TE_{12}$) durch die Differenz ($\delta TE$) zwischen den genannten Echozeitabständen ($\Delta TE_{12}$, $\Delta TE_{23}$) gebildet wird, Subtrahieren dieses skalierten dritten Differenzbilds von dem ersten Differenzbild ($\Delta\theta_1$), Quantisieren des Ergebnisses in Schritten von 2n, und Addieren des quantisierten Ergebnisses zu dem ersten Differenzbild ($\Delta\theta_1$), um ein verbessertes erstes Differenzbild ($\Delta\theta_1$') zu erhalten;
Skalieren des genannten dritten Phasenbilds ($\delta\theta$) um einen zweiten Skalierfaktor ($\sigma_2$), der durch Dividieren des

zweiten Echozeitabstands ($\Delta TE_{12}$) durch die Differenz ($\delta TE$) zwischen den genannten Echozeitabständen ($\Delta TE_{12}$, $\Delta TE_{23}$) gebildet wird, Subtrahieren dieses skalierten dritten Differenzbilds von dem zweiten Differenzbild ($\Delta\theta_2$), Quantisieren des Ergebnisses in Schritten von 2n, und Addieren des quantisierten Ergebnisses zu dem zweiten Differenzbild ($\Delta\theta_2$), um ein verbessertes zweites Differenzbild ($\Delta\theta_2$') zu erhalten;

Berechnen eines verbesserten dritten Differenzbilds ($\delta\theta$') zwischen dem verbesserten ersten und dem verbesserten zweiten Differenzbild ($\Delta\theta_1$', $\Delta\theta_2$');

Skalieren des genannten verbesserten dritten Differenzbilds um den genannten Skalierfaktor ($\sigma$);

Subtrahieren des genannten skalierten verbesserten dritten Differenzbilds von dem zu entfaltenden Phasenbild ($\theta_1$) ; und

Quantisieren des Ergebnisses der genannten Subtraktion in Schritten von 2n, um die Phasenkorrekturkarte ($\theta_{n1}$) zu erhalten.

5.  Verfahren zum Entfalten und Offset-Kompensieren eines Phasenbilds ($\theta_1$) in der Magnetresonanz-Bildgebung, umfassend:

Entfalten eines ersten und eines zweiten Phasenbilds ($\theta_1$, $\theta_2$), jeweils gemäß dem Verfahren nach einem der Ansprüche 1 bis 3;
Berechnen eines Offsetbilds ($\theta_{rx}$) aus dem genannten ersten und dem genannten zweiten entfalteten Phasenbild ($\theta_1$', $\theta_2$') gemäß

$$\theta_{rx} = \frac{\theta_2' \cdot TE_1 - \theta_1' \cdot TE_2}{TE_2 - TE_1}$$

wobei

$\theta_{rx}$ das genannte Offsetbild ist,
$\theta_1$' das genannte erste entfaltete Phasenbild ist, $\theta_2$' das genannte zweite entfaltete Phasenbild ist,
$TE_1$ die genannte erste Echozeit ist, und
$TE_2$ die genannte zweite Echozeit ist;

Subtrahieren des Offsetbilds ($\theta_{rx}$) von einem entfalteten Phasenbild ($\theta_1$'), das offsetkompensiert werden soll, um ein modifiziertes Offsetbild ($\theta_{rx1}$) zu erhalten;
Skalieren des genannten dritten Differenzbilds ($\delta\theta$) um den genannten Skalierfaktor ($\sigma$);
Subtrahieren des genannten skalierten Ergebnisses von dem genannten modifizierten Offsetbild ($\theta_{rx1}$);
Quantisieren des Subtraktionsergebnisses in Schritten von 2n; und
Addieren des quantisierten Ergebnisses zu dem genannten modifizierten Offsetbild ($\theta_{rx1}$).

6.  Verfahren zum Entfalten und Offset-Kompensieren eines Phasenbilds ($\theta_1$) in der Magnetresonanz-Bildgebung, umfassend:

Entfalten eines ersten und eines zweiten Phasenbilds ($\theta_1$, $\theta_2$), jeweils gemäß dem Verfahren nach Anspruch 4;
Berechnen eines Offsetbilds ($\theta_{rx}$) aus dem genannten ersten und dem genannten zweiten entfalteten Phasenbild ($\theta_1$', $\theta_2$') gemäß

$$\theta_{rx} = \frac{\theta_2' \cdot TE_1 - \theta_1' \cdot TE_2}{TE_2 - TE_1}$$

wobei

$\theta_{rx}$ das genannte Offsetbild ist,
$\theta_1$' das genannte erste entfaltete Phasenbild ist, $\theta_2$' das genannte zweite entfaltete Phasenbild ist,
$TE_1$ die genannte erste Echozeit ist, und
$TE_2$ die genannte zweite Echozeit ist;

Subtrahieren des Offsetbilds ($\theta_{rx}$) von einem entfalteten Phasenbild ($\theta_1$'), das offsetkompensiert werden soll, um ein modifiziertes Offsetbild ($\theta_{rx1}$) zu erhalten;

Skalieren des genannten verbesserten dritten Differenzbilds ($\delta\theta$') um den genannten Skalierfaktor ($\sigma$);

Subtrahieren des genannten skalierten Ergebnisses von dem genannten modifizierten Offsetbild ($\theta_{rx1}$);

Quantisieren des Subtraktionsergebnisses in Schritten von 2n; und

Addieren des quantisierten Ergebnisses zu dem genannten modifizierten Offsetbild ($\theta_{rx1}$).

## Revendications

1. Procédé de dépliement d'une image de phase ($\theta_1$) en Imagerie de Résonance Magnétique, comprenant l'acquisition de trois images de phase ($\theta_1$, $\theta_2$, $\theta_3$) à trois temps d'écho différents ($TE_1$, $TE_2$, $TE_3$) après une excitation unique avec des espacements de temps d'écho inégaux ($\Delta TE_{12}$, $\Delta TE_{23}$) entre eux,

le calcul d'une première image de différence ($\Delta\theta_1$) entre les deux premières et d'une seconde image de différence ($\Delta\theta_2$) entre les deux dernières desdites trois images de phase ($\theta_1$, $\theta_2$, $\theta_3$) et le calcul d'une troisième image de différence ($\delta\theta$) entre la première et la seconde image de différence ($\Delta\theta_1$, $\Delta\theta_2$),

la génération d'une cartographie de correction de phase ($\theta_{n1}$) sur la base au moins de ladite troisième image de différence ($\delta\theta$) et de l'image de phase ($\theta_1$) à déplier, et

l'addition de ladite cartographie de correction de phase ($\theta_{n1}$) à l'image de phase ($\theta_1$) à déplier desdites images de phase ($\theta_1$, $\theta_2$, $\theta_3$) acquises.

2. Procédé selon la revendication 1, dans lequel l'étape de génération de la cartographie de correction de phase ($\theta_{n1}$) comprend

le redimensionnement de ladite troisième image de différence ($\delta\theta$) par un facteur d'échelle ($\sigma$),

la soustraction de ladite troisième image de différence redimensionnée à partir de l'image de phase ($\theta_1$) à déplier, et

la quantification du résultat de ladite soustraction par étapes de 2n pour obtenir la cartographie de correction de phase ($\theta_{n1}$).

3. Procédé selon la revendication 2, dans lequel ledit facteur d'échelle ($\sigma$) est formé en divisant le temps d'écho ($TE_1$) de l'image de phase ($\theta_1$) à déplier par la différence ($\delta TE$) entre lesdits espacements de temps d'écho ($\Delta TE_{12}$, $\Delta TE_{23}$).

4. Procédé selon la revendication 1, dans lequel l'étape de génération de la cartographie de correction de phase ($\theta_{n1}$) comprend

le redimensionnement de ladite troisième image de différence ($\delta\theta$) par un premier facteur d'échelle ($\sigma_1$) formé en divisant le premier espacement du temps d'écho ($\Delta TE_{12}$) par la différence ($\delta TE$) entre lesdits espacements de temps d'écho ($\Delta TE_{12}$, $\Delta TE_{23}$), la soustraction de cette troisième image de différence redimensionnée à partir de la première image de différence ($\Delta\theta_1$), la quantification du résultat par étapes de 2n, et l'addition du résultat quantifié à la première image de différence ($\Delta\theta_1$), pour obtenir une première image de différence améliorée ($\Delta\theta_1$') ;

le redimensionnement de ladite troisième image de différence ($\delta\theta$) par un second facteur d'échelle ($\sigma_2$) formé en divisant le second espacement du temps d'écho ($\Delta TE_{23}$) par la différence ($\delta TE$) entre lesdits espacements de temps d'écho ($\Delta TE_{12}$, $\Delta TE_{23}$), la soustraction de cette troisième image de différence redimensionnée à partir de la seconde image de différence ($\Delta\theta_2$), la quantification du résultat par étapes de 2n, et l'addition du résultat quantifié à la seconde image de différence ($\Delta\theta_2$), pour obtenir une seconde image de différence améliorée ($\Delta\theta_2$') ;

le calcul d'une troisième image de différence améliorée ($\delta\theta$') entre la première et la seconde image de différence améliorée ($\Delta\theta_1$', $\Delta\theta_2$');

le redimensionnement de ladite troisième image de différence améliorée ($\delta\theta$') par ledit facteur d'échelle ($\sigma$) ;

la soustraction de ladite troisième image de différence améliorée à partir de l'image de phase ($\theta_1$) à déplier ; et

la quantification du résultat de ladite soustraction par étapes de 2n, pour obtenir la cartographie de correction de phase ($\theta_{n1}$).

5. Procédé de dépliement et de compensation du décalage d'une image de phase ($\theta_1$) en Imagerie de Résonance Magnétique, comprenant :

le dépliement d'une première et d'une seconde image de phase ($\theta_1$, $\theta_2$) chacune d'après le procédé selon l'une quelconque des revendications 1 à 3 ;

le calcul d'une image de compensation de décalage ($\theta_{rx}$) à partir de la première et de la seconde image de phase dépliée ($\theta_1$', $\theta_2$') selon

$$\theta_{rx} = \frac{\theta_2' \cdot TE_1 - \theta_1' \cdot TE_2}{TE_2 - TE_1}$$

avec

$\theta_{rx}$ étant ladite image de compensation de décalage,
$\theta_1'$ étant ladite première image de phase dépliée,
$\theta_2'$ étant ladite seconde image de phase dépliée,
$TE_1$ étant ledit premier temps d'écho, et
$TE_2$ étant ledit second temps d'écho ;

la soustraction de l'image de compensation de décalage ($\theta_{rx}$) à partir de l'image de phase dépliée ($\theta_1'$) à compenser en décalage, pour obtenir une image de compensation de décalage modifiée ($\theta_{rx1}$) ;
le redimensionnement de ladite troisième image de différence ($\delta\theta$) par ledit facteur d'échelle ($\sigma$) ;
la soustraction dudit résultat redimensionné à partir de ladite image de compensation de décalage modifiée ($\theta_{rx1}$) ;
la quantification du résultat de la soustraction par étapes de 2n ; et
l'addition du résultat quantifié à ladite image de compensation modifiée ($\theta_{rx1}$).

6. Procédé de dépliement et de compensation du décalage d'une image de phase ($\theta_1$) en Imagerie de Résonance Magnétique, comprenant :

le dépliement d'une première et d'une seconde image de phase ($\theta_1$, $\theta_2$) chacune d'après le procédé selon la revendication 4 ;
le calcul d'une image de compensation de décalage ($\theta_{rx}$) à partir de la première et de la seconde image de phase dépliée ($\theta_1'$, $\theta_2'$) selon

$$\theta_{rx} = \frac{\theta_2' \cdot TE_1 - \theta_1' \cdot TE_2}{TE_2 - TE_1}$$

avec

$\theta_{rx}$ étant ladite image de compensation de décalage,
$\theta_1'$ étant ladite première image de phase dépliée,
$\theta_2'$ étant ladite seconde image de phase dépliée,
$TE_1$ étant ledit premier temps d'écho, et
$TE_2$ étant ledit second tems d'écho ;

la soustraction de l'image de compensation de décalage ($\theta_{rx}$) à partir de l'image de phase dépliée ($\theta_1'$) à compenser en décalage, pour obtenir une image de compensation de décalage modifiée ($\theta_{rx1}$) ;
le redimensionnement de ladite troisième image de différence améliorée ($\delta\theta'$) par ledit facteur d'échelle ($\sigma$) ;
la soustraction dudit résultat redimensionné à partir de ladite image de compensation de décalage modifiée ($\theta_{rx1}$) ;
la quantification du résultat de la soustraction par étapes de 2n ; et
l'addition du résultat quantifié à ladite image de compensation modifiée ($\theta_{rx1}$).

**Fig. 1**

**Fig. 3**

$$\text{acquire } \theta_1, \theta_2, \theta_3 \text{ at } TE_1, TE_2, TE_3 \quad 6$$

$$\text{calc } \Delta\theta_1 = \theta_2 - \theta_1, \Delta\theta_2 = \theta_3 - \theta_2 \quad 11$$

$$\text{calc } \delta\theta = \Delta\theta_2 - \Delta\theta_1 \quad 12$$

$$\text{gen } \theta_{n1} \quad 13$$

$$\theta_1' := \theta_1 + \theta_{n1} \quad 17$$

**Fig. 2**

*Fig. 4*

$$\text{scale } \delta\theta \cdot \sigma \qquad 14$$

$$\text{subtract } \theta_1 \qquad 15$$

$$\theta_{n1} := \text{quantize}_{2\pi} [\ ] \qquad 16$$

*Fig. 5*

**18'**

**19a** → scale $\delta\theta \cdot \sigma_1$

**20a** → subtract $\Delta\theta_1$

**21a** → $\Delta\theta_{n1} := \text{quantize}_{2\pi}\,[\ ]$

**22a** → $\Delta\theta_1' := \Delta\theta_1 + \Delta\theta_{n1}$

**18''**

scale $\delta\theta \cdot \sigma_2$ ← **19b**

subtract $\Delta\theta_2$ ← **20b**

$\Delta\theta_{n2} := \text{quantize}_{2\pi}\,[\ ]$ ← **21b**

$\Delta\theta_2' := \Delta\theta_2 + \Delta\theta_{n2}$ ← **22b**

calc $\delta\theta' = \Delta\theta_2' - \Delta\theta_1'$ — **23**

scale $\delta\theta' \cdot \sigma$ — **24**

subtract $\theta_1$ — **25**

$\theta_{n1} := \text{quantize}_{2\pi}\,[\ ]$ — **26**

*Fig. 6*

a) $\Delta\theta_1$ $\Delta\theta_2$

b) $\delta\theta$

c) $\Delta\theta_{n1}$ $\Delta\theta_{n2}$

d) $\Delta\theta_1'$ $\Delta\theta_2'$

e) $\delta\theta'$

*Fig. 7*

27 — unwrap $\theta_1$, $\theta_2$

28 — calc $\theta_{rx}$

29 — calc $\theta_{rx1} = \theta_1' - \theta_{rx}$

30 — scale $\delta\theta \cdot \sigma$ or $\delta\theta' \cdot \sigma$

31 — subtract $\theta_{rx1}$

32 — $\theta_{n1,rx} := \text{quantize}_{2\pi}[\ ]$

33 — $\theta_1'' := \theta_{rx1} + \theta_{n1,rx}$

*Fig. 8*

*Fig. 9*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• US 20090256567 A1

### Non-patent literature cited in the description

• Regularized Field Map Estimation in MRI. **FUNAI A. K. et al.** IEEE Transactions on Medical Imaging. IEEE USA, October 2008, vol. 27, 1484-1494